(19) Europäisches Patentamt / European Patent Office / Office européen des brevets

(11) **EP 1 282 940 B1**

(12) **EUROPÄISCHE PATENTSCHRIFT**

(45) Veröffentlichungstag und Bekanntmachung des Hinweises auf die Patenterteilung:
**01.10.2008   Patentblatt 2008/40**

(21) Anmeldenummer: **01936029.6**

(22) Anmeldetag: **04.05.2001**

(51) Int Cl.:
*H03F 3/45* *(2006.01)*   *H03F 3/30* *(2006.01)*

(86) Internationale Anmeldenummer:
**PCT/DE2001/001664**

(87) Internationale Veröffentlichungsnummer:
**WO 2001/086805 (15.11.2001 Gazette 2001/46)**

(54) **STROMSPIEGEL UND VERFAHREN ZUM BETREIBEN EINES STROMSPIEGELS**

CURRENT MIRROR AND METHOD FOR OPERATION THEREOF

MIROIR DE COURANT ET PROCEDE PERMETTANT DE LE FAIRE FONCTIONNER

(84) Benannte Vertragsstaaten:
**DE FR GB**

(30) Priorität: **05.05.2000   DE 10021928**

(43) Veröffentlichungstag der Anmeldung:
**12.02.2003   Patentblatt 2003/07**

(73) Patentinhaber: **Infineon Technologies AG**
**81669 München (DE)**

(72) Erfinder: **PAULUS, Christian**
**81247 München (DE)**

(74) Vertreter: **Schweiger, Martin**
**Karlstrasse 35**
**80333 München (DE)**

(56) Entgegenhaltungen:
**EP-A- 0 412 566       EP-A- 0 651 502**
**EP-A- 0 690 561       US-A- 5 894 245**

- LU G N ET AL: "A CMOS OP AMP USING A REGULATED-CASCODE TRANSIMPEDANCE BUILDING BLOCK FOR HIGH-GAIN, LOW-VOLTAGE ACHIEVEMENT" ISCAS '97. PROCEEDINGS OF THE 1997 IEEE INTERNATIONAL SYMPOSIUM ON CIRCUITS AND SYSTEMS. CIRCUITS AND SYSTEMS IN THE INFORMATION AGE. HONG KONG, JUNE 9 - 12, 1997, IEEE INTERNATIONAL SYMPOSIUM ON CIRCUITS AND SYSTEMS, NEW-YORK, NY: IEEE, US, Bd. 1, 9. Juni 1997 (1997-06-09), Seiten 165-168, XP000805367 ISBN: 0-7803-3584-8

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft einen Stromspiegel, bei dem ein Eingangsstrom ($I_{in}$) in einer Stromsenke nichtlinear in eine Spannung gewandelt wird, wobei die Spannung zur Ansteuerung einer Stromquelle ($I_{out}$) mit im Wesentlichen gleicher Übertragungskennlinie dient.

Die Erfindung betrifft ferner ein Verfahren zum Betreiben eines Stromspiegels.

Stromspiegel sind Schaltungen, beziehungsweise Schaltungsbestandteile, die in Reaktion auf einen Strom einen Strom in gleicher Stärke erzeugen.

Insbesondere bei integrierten Schaltungen, in denen eine Datenverarbeitung aufgrund von Stromsignalen erfolgt, ist es bekannt, Stromspiegel einzusetzen.

Ein Stromspiegel ist vorzugsweise eine Schaltung oder ein Schaltungsteil. Er wandelt einen Eingangsstrom in einen Ausgangsstrom. Vorzugsweise besteht zwischen dem Eingangsstrom und dem Ausgangsstrom ein linearer Zusammenhang.

Es ist bekannt, geeignet geschaltete Transistoren als Stromsenke beziehungsweise als Stromquelle einzusetzen.

Aus dem Buch C. Toumazou, F.J. Lidgey und D.G. Haigh: "Analogue IC design: the current mode approach", London 1990, sind verschiedene Schaltungsanordnungen für Stromspiegel bekannt.

Insbesondere in hochgenauen, integrierten Analogschaltungen wird üblicherweise eine differentielle Signalverarbeitung verwendet, um die Empfindlichkeit der Schaltungen auf Störeinflüsse verschiedenster Art zu reduzieren. Während Schaltungen, deren Informationsübertragung in der Spannungsdomäne erfolgt, dies durch Verwendung von volldifferentiellen Operationsverstärkern (hohes CMRR, PSRR, etc.) erreichen, muß in current-mode Schaltungen auf andere Lösungen zurückgegriffen werden. Häufig wird dort eine quasidifferentielle Stromsignalverarbeitung angewandt, bei der zwei identische, elektrisch jedoch getrennte Schaltungen parallel verwendet werden. Durch die fehlende direkte elektrische Kopplung sowie die unter Umständen große räumliche Trennung der beiden Signalpfade auf dem Chip relativieren sich die Vorteile der differentiellen Signalverarbeitung.

Weitere bekannte Ausführungsformen wie z.B. in EP-A-0 651 502 basieren zumeist auf der Verwendung von differentiellen Stufen, was Nachteile in Bezug auf Bauteilmismatch sowie Geschwindigkeit und Ausgangsspannungsbereich des Stromspiegels zur Folge hat. Die Erfindung umfasst eine volldifferentielle symmetrische Stromspiegeleinheit, deren beide Signalpfade direkt gekoppelt sind. Dadurch ergeben sich Vorteile bei der Störsignalunterdrückung.

Der Erfindung liegt die Aufgabe zugrunde, einen Stromspiegel zu schaffen, der eine möglichst hohe Stabilität insbesondere im Hinblick auf Gleichtaktsignale aufweist.

Diese Aufgabe wird durch den Gegenstand des unabhängigen Anspruchs gelöst. Vorteilhafte Weiterbilden ergeben sich aus den abhängigen Ansprüchen.

Erfindungsgemäß wird dabei unter einer "spannungsgesteuerten Stromquelle" jegliches Bauelement oder jegliche Baugruppe verstanden, das bzw. die bei Anlegen einer Eingangsspannung einen Ausgangsstrom erzeugt. Im einfachsten Fall kann dies ein MOS-Transistor sein, an dessen Gate eine Spannung angelegt wird, wobei an den Source-Drain-Anschlüssen ein Strom entsteht. Es ist auch denkbar, einen Bipolartransistor einzusetzen. Es sind auch Baugruppen von zwei Transistoren, drei Transistoren oder auch komplexeren spannungsgesteuerten Stromquellen denkbar.

Erfindungsgemäß wird diese Aufgabe insbesondere dadurch gelöst, daß der Stromspiegel eine weitere spannungsgesteuerte Stromquelle enthält, die einen Hilfsstrom ($a \cdot I_{out} = a \cdot n \cdot I_{in}$) liefert.

Der Begriff "Gleichtaktunterdrückung" wird im Zusammenhang mit Differenzverstärkern bzw. Operationsverstärkern verwendet und bezeichnet deren Eigenschaft, ein Gleichtaktsignal, das an den Eingängen der Schaltung anliegt zu unterdrücken. An den Ausgängen der Schaltung erscheint lediglich das z. B. verstärkte Differenzsignal.

In diesem Sinne ist auch eine Gleichtaktunterdrückung bei Stromspiegeln zu verstehen. Unabhängig vom Gleichtaktanteil an den Eingängen der Stromspiegelschaltung soll an dem erfindungsgemäßen Stromspiegel lediglich das Differenzsignal am Ausgang erscheinen.

Der Parameter a bezeichnet den Bruchteil des Ausgangsstromes der Stromspiegelschaltung, der als Hilfsstrom zur Verfügung gestellt wird, um eine Korrektur des Störsignals in der erfindungsgemäßen differentiellen Stromspiegelschaltung zu erreichen.

Die Erfindung sieht insbesondere vor, einen volldifferentiellen Stromspiegel ohne die Verwendung differentieller Stufen aufzubauen, was Vorteile hinsichtlich Ausgangsspannungsbereich, Bauteilmismatch und auch Stabilität beziehungsweise Bandbreite der Gesamtschaltung hat.

Die Erfindung umfaßt eine symmetrische Stromspiegeleinheit, in der ein Störsignal (common-mode Anteil) des differentiellen Signals durch eine geeignete Zusatzschaltung vom Ausgangsstrom abgezogen wird.

Stromspiegel unter Verwendung von MOS-Transistoren basieren darauf, daß ein Eingangsstrom ($I^+_{in} = I_o$ beziehungsweise $I^-_{in} = -I_o$) in einer Stromsenke nichtlinear in eine Spannung gewandelt wird, die zur Ansteuerung einer Stromquelle ($I^+_{out} = -n \cdot I_o$, beziehungsweise $I^-_{out} = n \cdot I_o$) mit gleicher Übertragungskennlinie dient. Der so gebildete Stromspiegel wird nun durch eine weitere spannungsgesteuerte Stromquelle erweitert, die einen Strom von $a \cdot I_{out}^+ = -a \cdot n \cdot I_o$ liefert. Dieser Hilfsstrom wird mit der entsprechenden Hilfsstromquelle des identischen zweiten differentiellen Zweiges verbunden, die einen Ausgangsstrom von $a \cdot I_{out}^- = a \cdot n \cdot I_o$ abführt. Die bei-

den Ströme kompensieren sich in diesem Fall. Tritt eine Asymmetrie im Eingangssignal auf (common-mode-Anteil), werden sich die Hilfsströme nicht kompensieren und der resultierende Fehlerstrom δI kann mit Hilfe eines weiteren Stromspiegels mit einem Übertragungsverhältnis von 1/2a von den differentiellen Ausgangssignalen abgezogen werden. Dadurch ergibt sich eine rechnerisch vollständige common-mode Unterdrückung.

Es ist zweckmäßig, den Stromspiegel so zu gestalten, daß in einem zusätzlichen Zweig eine zusätzliche spannungsgesteuerte Stromquelle einen zusätzlichen Hilfsstrom erzeugt.

Vorteilhafterweise wird der Stromspiegel dabei so gestaltet, daß der Hilfsstrom und der zusätzliche Hilfsstrom so addiert werden, daß ein δI resultiert.

In der Praxis ist es vorteilhaft,

$$a = \frac{1}{2} \ oder \ a = 1$$

zu wählen, da dann der gesamte Stromspiegel unter Verwendung identischer n-MOS-, beziehungsweise p-MOS-Transistoren, aufgebaut werden kann.

Vorteile der Schaltung sind die einfache Implementierung als Zusatzmodul zu bestehenden Stromspiegeleinheiten sowie die weitgehende Unabhängigkeit der vorgestellten Architektur von der Grundstruktur des eingesetzten Stromspiegels. Ferner entstehen durch die fehlende Rückkopplung in der Schaltung keine Stabilitätsprobleme, so daß die Schaltung in besonderem Maße für Anwendungen mit hoher Signalbandbreite geeignet ist.

Ein wichtiger Vorteil der Erfindung ist, volldifferentielle Stromspiegelstrukturen ohne Verwendung einer differentiellen Stufe realisieren zu können (siehe Ausführungsbeispiel), die verschiedene Nachteile bezüglich Bandbreite, Ausgangsspannungsbereich und Empfindlichkeit auf Bauteilmismatch aufweist.

Es ist zweckmäßig, daß wenigstens einer der Stromquellen durch mindestens einen Transistor gebildet wird und/oder daß wenigstens einer der Stromquellen kaskadierte Transistoren enthält.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Zeichnungen.

Erfindungsgemäß wird folgende begriffliche Unterscheidung gewählt. Bei der gewöhnlichen Signalverarbeitung in Schaltungen wird die zu verarbeitende Information durch ein elektrisches Signal (im allgemeinen eine Spannung) repräsentiert. Bezogen auf ein Referenzsignal (z. B. Masse) ergibt sich die Größe des Signals aus der Differenz zwischen dem (festen) Referenzsignal und dem Signal auf der Signalleitung. Diese auf absolute Werte beruhende Signalverarbeitung wird im allgemeinen als "single ended" bezeichnet.

Im Gegensatz dazu wird bei der differentiellen (= volldifferentiellen) Signalverarbeitung, die Information auf zwei Leitungen übertragen. Leitung 1 führt das Signal, Leitung 2 das invertierte Signal. Die Information, die die Signale repräsentieren, erhält man, indem man die Differenz zwischen den beiden Signalleitungen bildet. Der wesentliche Vorteil dieser differentiellen Signalverarbeitung ist die deutlich verminderte Störempfindlichkeit auf Einkopplungen von benachbarten bzw. die Signalleitungen kreuzenden Leitungen. Beim "singleended" Verfahren addiert sich ein derartig eingekoppelte Störsignal zum Nutzsignal und wird in der Schaltung weiterverarbeitet. In der differentiellen Signalverarbeitung addiert sich die Störung auf beide signalführende Leitungen. Durch die Differenzbildung am Ausgang der Schaltung wird der Störanteil des Signals somit wieder eliminiert. Die differentielle Architektur eignet sich somit insbesondere für Schaltungen, in denen sehr kleine Signale verarbeitet werden müssen oder eine sehr präzise Signalverarbeitung erfolgen muß. Weitere Informationen zu diesem Thema sind zu finden in: "Design of analog integrated circuits and systems" von Kenneth R. Laker & Willy M.C. Sansen, McGraw-Hill Verlag, ISBN 0-07-036060-X, Seite 456ff).

In diesem Sinne bezeichnet der Begriff "quasidifferentieller Stromspiegel" eine Stromspiegelschaltung, bei der zwar zwei Signalwege für das Signal und das invertierte Signal vorhanden sind, jedoch keine Eliminierung der Störung innerhalb der Schaltung erfolgt. Die Störung wird also an die dem Stromspiegel folgende Stufe weitergegeben und kann dort oder in einer späteren Stufe in der Signalverarbeitungskette zu einer Beeinträchtigung des Signals (z. B. durch Sättigungseffekte) führen.

Die Begriffe "differentielle", "volldifferentielle" und "volldifferentielle symmetrische Stromspiegel" bezeichnen die selbe Schaltungsarchitektur. Hier wird eine Stromspiegelschaltung aufgebaut, die zwei Signalpfade aufweist - für den nichtinvertierten Signalstrom und den invertierten Signalstrom. Ferner wird schaltungsintern eine Kompensation des Gleichtaktanteils (=Störsignal) durchgeführt, so daß am Ausgang des Stromspiegels lediglich das Nutzsignal anliegt.

Der Begriff "differentielle Signalverarbeitung" kann in "Design of analog integrated circuits and systems" von Kenneth R. Laker & Willy M.C. Sansen, McGraw-Hill Verlag, ISBN 0-07-036060-X, Seite 456ff) nachgeschlagen werden. Der Begriff "quasidifferentiell" wird von der Anmelderin im Zusammenhang mit dieser Thematik häufig verwendet.

Wenn die Einrichtung zur Erzeugung des positiven Ausgangsstroms ($I_{out}$ +) und des negativen Ausgangsstroms ($I_{out}$ -) durch Abziehen des Störsignals ($I_{cor}$) von einer Kopie des positiven Eingangsstrom ($I_{in}$ +) bzw. von einer Kopie des negativen Eingangsstrom ($I_{in}$ -) wenigstens einen komplementären Stromspiegel (M11, M14; M12, M15; M13, M16) aufweist, dann können sowohl positive als auch negative Störungen abgezogen werden.

In den Zeichnungen zeigt

Fig. 1      einen quasidifferentiellen Stromspiegel,

Fig. 2      einen volldifferentiellen Stromspiegel, basierend auf einer differentiellen Stufe,

Fig. 3      ein verallgemeinertes Prinzipschaltbild des erfindungsgemäßen volldifferentiellen Stromspiegels,

Fig. 4      ein Ausführungsbeispiel eines erfindungsgemäßen volldifferentiellen Stromspiegels,

Fig. 5      eine Schaltungsanordnung zur Simulation des Verhaltens der Schaltung aus Figur 4,

Fig. 6      die Zeitabhängigkeit der Ströme für die Schaltung aus Figur 5.

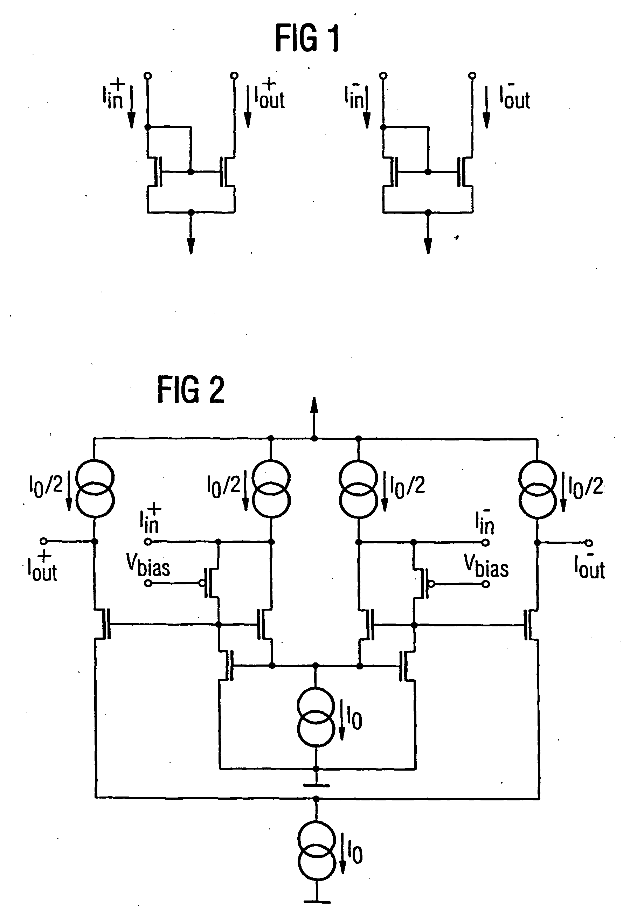

Der in Fig. 1 dargestellte quasidifferentielle Stromspiegel ermöglicht eine Bildung eines Differenzsignals zwischen verschiedenen Schaltungsbestandteilen.

In Fig. 2 ist eine Möglichkeit dargestellt, wie ein volldifferentieller Stromspiegel unter Verwendung einer differentiellen Stufe aufgebaut werden kann. Ein solcher Stromspiegel ist beispielsweise durch Bengt Jonsson, "Switched-Current Circuits: from Building Blocks to Mixed Analog-Digital Systems" Vortrag im Department of Electronics, Electronic System Design, Electrum 229, Isafjordsgatan 22-26, S-164 40 Kista, Schweden am 25. Januar 1999 bekannt. Bei dieser Stromspiegelschaltung ist folgendes besonders problematisch. Diese Schaltung ist besonders aufwendig ausgebildet. Für breitbandige Anwendungen, bei denen hochfrequente Ströme gespiegelt werden müssen, ergeben sich bei dieser Schaltung Probleme, weil die Stromspiegelung nicht schnell genug bzw. genau genug funktioniert.

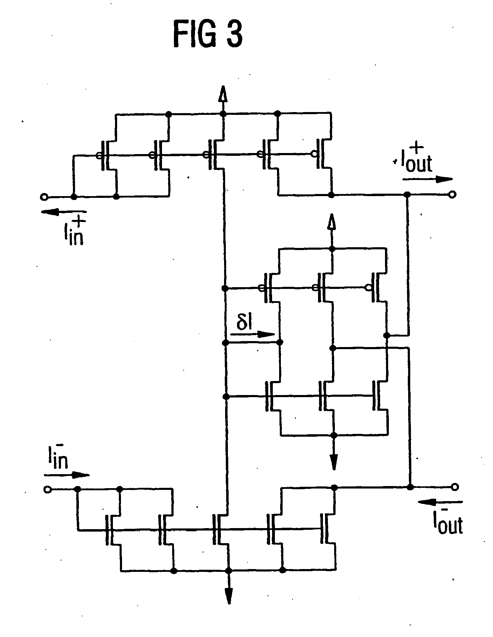

In Fig. 3 ist ein Prinzipschaltbild eines erfindungsgemäßen volldifferentiellen Stromspiegels unter Einsatz von MOS-Transistoren als Stromquellen und -senken dargestellt.

Dabei ist eine Anordnung mit a = ½ dargestellt. Alle hier verwendeten Transistoren seien gleich, weshalb sich a = ½ ergibt. Durch Ersetzung der einfachen Transistoren durch Kaskoden-Stromquellen wird die Linearität der Schaltung verbessert.

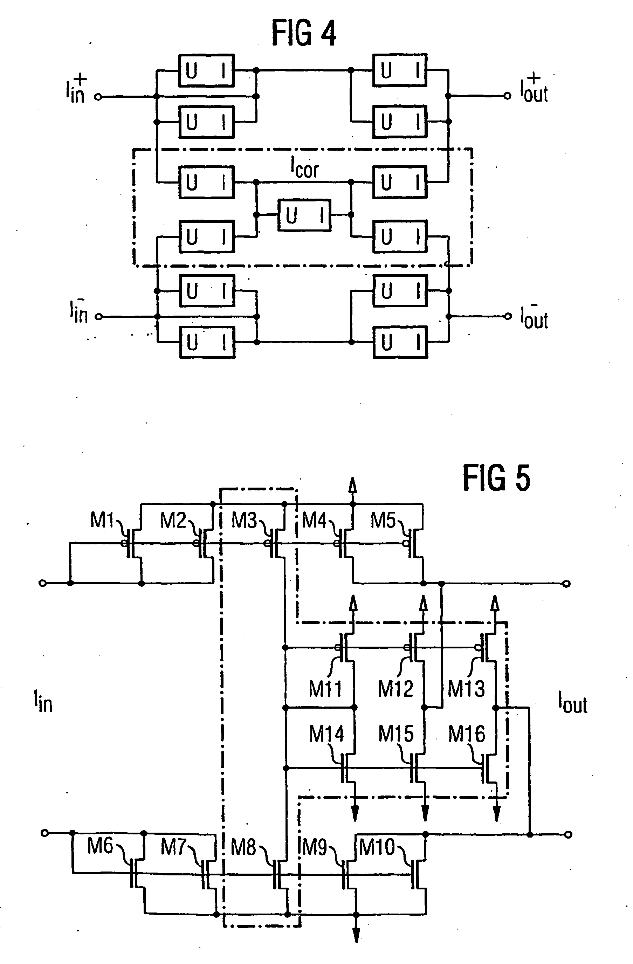

Eine bevorzugte Architektur für volldifferentielle Stromspiegel ist in Fig. 4 dargestellt.

Figur 4 zeigt eine schematische Darstellung, die das Grundprinzip der erfindungsgemäßen Stromspiegelschaltung veranschaulicht. Figur 4 zeigt eine Reihe von Spannungs-Strom-Wandlern "U I". Die Spannungs-Strom-Wandler "U I" sind jeweils als "Blackbox" mit einem Eingang und mit einem Ausgang dargestellt. Der Eingang ist dabei in dem entsprechenden Symbol dort vorgesehen, wo sich das Symbol "U" befindet. Der jeweilige Ausgang befindet sich dort, wo sich das Symbol "I" befindet. Im einfachsten Fall kann ein solcher "U I"-Wandler als Transistor ausgebildet sein. In CMOS-Technik wird der "U I"-Wandler durch einen Transistor dargestellt, wobei der Eingang "U" am sogenannten "Gate" des betreffenden Transistors vorgesehen ist. Der Ausgang wird dann durch die beiden Kanalanschlüsse des betreffenden Transistors bereitgestellt.

Im Folgenden wird zur Erläuterung der Architektur lediglich das Symbol einer spannungsgesteuerten Stromquelle - U I - verwendet. Unter der Annahme, daß alle spannungsgesteuerten Stromquellen identisch sind, ergeben sich folgende Zusammenhänge für die Signalströme in der Schaltung:

$$I_{in}^{+} = I_0 + \delta I$$

$$I_{in}^{-} = -I_0 + \delta I$$

$$\cdot I_{cor} = \tfrac{1}{2} I_{in}^{+} + \tfrac{1}{2} I_{in}^{-} = \delta I$$

$I_0$ stellt hier den Signalstrom dar, während $\delta I$ die Störgröße repräsentiert (common-mode Anteil), die durch die Schaltungsarchitektur wieder vom Ausgangssignal abgezogen wird.

Die erfindungsgemäße differentielle Stromspiegelschaltung, wie sie in Figur 4 dargestellt ist, weist zwei Anschlüsse für das differentielle Eingangssignal ($I_{in}^{+}$ bzw. $I_{in}^{-}$) und zwei Anschlüsse für das Ausgangssignal ($I_{out}^{+}$ bzw. $I_{out}^{-}$) auf. Im Sinne einer ungestörten, differentiellen Signalverarbeitung wird an den einen Eingang der Schaltung der Strom $I_{in}^{+}=I_0$ angelegt, an den zweiten Eingang der dazu inverse Strom $I_{in}^{-}=-I_0$. Anschaulich bedeutet dies, daß in den einen Anschluß ein Strom eingeprägt wird (positives Vorzeichen) und aus dem anderen Anschluß ein Strom entnommen wird (negatives Vorzeichen). Der Eingangsstrom $I_{in}^{+}=I_0$, wird durch die als Stromsenke geschalteten MOS-Transistoren M1 und M2 (nichtlinear) in eine Spannung umgesetzt, die gleichzeitig das Gatepotential der Transistoren M3, M4 und M5 bildet. Die integrierten MOS-Transistoren M1 - M5 weisen die gleichen physikalischen bzw. geometrischen Eigenschaften auf (Weite/Länge) und haben somit - im Rahmen von Fertigungstoleranzen - die gleichen elektrischen Eigenschaften. Aus diesem Grund wird am Ausgang $I_{out}^{+}$ eine exakte Kopie des Eingangsstromes zur Verfügung gestellt: $I_{out}^{+}=-I_0$ (Stromspiegelfunktion). Analog erscheint am Ausgang des Signalzweiges für den invertierten Signalstrom (Transistoren M6 - M10) ein

Ausgangsstrom $I_{out}^-=I_0$. Die Transistoren M3 und M8 stellen ebenfalls jeweils Stromquellen dar und stellen in dieser Ausführungsform jeweils die Hälfte des jeweiligen Eingangsstromes als Hilfsstrom $I_{aux}^+=-\frac{1}{2}I_{in}^+$ bzw. $I_{aux}^-=-\frac{1}{2}I_{in}^-$ zur Verfügung. Die Addition der beiden Hilfsströme ergibt den Korrekturstrom $\delta I$. Die konventionelle Stromspiegelschaltung bestehend aus den MOS-Transistoren M11 - M16 stellt von diesem Korrekturstrom zwei Kopien her, die jeweils zu den Ausgangsströmen $I_{out}^+$ bzw. $I_{out}^-$ addiert werden. Im Falle eines störungsfreien Eingangssignals kompensieren sich die beiden Hilfsströme exakt $\delta I= I_{aux}^++I_{aux}^-=-\frac{1}{2}I_{in}^+-\frac{1}{2}I_{in}^-=-\frac{1}{2}I_0+\frac{1}{2}I_0=0$) und die Korrekturschaltung liefert kein Korrektursignal.

Liegen am Eingang der erfindungsgemäßen Stromspiegelschaltung hingegen zusätzlich zum differentiellen Eingangssignal auf beide Leitungen geichermaßen eingekoppelte Störsignale $I_{dis}$ an ($I_{in}^+=I_0+I_{dis}$ bzw. $I_{in}^-=-I_o+I_{dis}$), so resultiert in der erfindungsgemäßen Schaltung ein Korrekturstrom $\delta I= I_{aux}^++I_{aux}^-=-\frac{1}{2}I_{in}^+-\frac{1}{2}I_{in}^-=-\frac{1}{2}I_0+\frac{1}{2}I_{dis}+\frac{1}{2}I_0+\frac{1}{2}I_{dis}=I_{dis}$. Dieser Korrekturstrom wird durch die Korrektorschaltung in den beiden Signalzweigen jeweils vom gespiegelten Eingangsstrom abgezogen: $I_{out}^+=-I_0-I_{dis}+I_{dis}=-I_0$ bzw. $I_{out}^-=I_0+I_{dis}-I_{dis}=I_0$. Als Ausgangssignal der erfindungsgemäßen Stromspiegelschaltung erhält man daher das ungestörte Eingangssignal welches von den folgenden Schaltungsblöcken dann weiterverarbeitet werden kann.

Die beschriebene Funktionsweise der Schaltung ist unabhängig von den Übertragungseigenschaften des Stromspiegels. Im zuvor beschriebenen Beispiel (Figur 4) wurde von einem Spiegelungsverhältnis $I_{out}:I_{in}$ von 1:1 ausgegangen. Die erfindungsgemäße Schaltung kann jedoch für beliebige Spiegelungsverhältnisse n= $I_{out}:I_{in}$ ausgelegt werden. In diesem Falle muß der Korrekturstrom mit dem entsprechenden Verhältnis n mitskaliert werden um eine vollständige Eliminierung eines Störanteils im Signal zu erreichen. Ferner muß der Hilfsstrom nicht zwingend die halbe Größe des Eingangsstromes aufweisen. Vielmehr kann hierzu ein beliebiger Bruchteil oder ein Vielfaches a des Ausgangsstromes dienen. Das Übertragungsverhätnis des Korrekturstromspiegels muß dann entsprechend angepaßt werden.

Weiterhin kann die erfindungsgemäße Stromspiegelschaltung auch mehrere Ausgangsstufen aufweisen, beispielsweise um mehrere Kopien des Eingangsstromes bereitzustellen. In diesem Fall muß die Korrekturschaltung mit weiteren, entsprechend skalierten Korrekturstromspiegeln ausgeführt sein, um alle Ausgangsströme der Gesamtschaltung korrigieren zu können.

In Figur 4 sind die Stromsenken bzw. -quellen durch einfache MOS-Transistoren ausgeführt. Um eine bessere Übertragungsgenauigkeit der erfindungsgemäßen Stromspiegelschaltung zu erreichen, können dort ebenfalls Kaskode-Stromquellen oder aktive Stromquellen eingesetzt werden. Allgemein ausgedrückt kann als Stromsenke bzw. Stromquelle in der erfindungsgemäßen Schaltung jede Art einer spannungsgesteuerten Stromquelle verwendet werden.

In Figur 4 entsprechen diejenigen Bereiche der dort gezeigten Schaltung, die sich außerhalb eines sogenannten Korrekturschaltungsbereichs befinden, der Stromspiegelschaltung des Standes der Technik gemäß Figur 1. Der Korrekturschaltungsbereich ist in Figur 4 in einer strichpunktierten Linie dargestellt, die lediglich einen Bereich festlegt. Diese fiktive Bereichs-umgrenzung hat auf die Funktionsweise der Schaltung keinen Einfluß.

Ein bevorzugtes Ausführungsbeispiel mit a = ½ und jeweils identischen Transistoren

    M1 bis M5
    M6 bis M10
    M11 bis M13
    M14 bis M16 ist in Fig. 5 dargestellt.

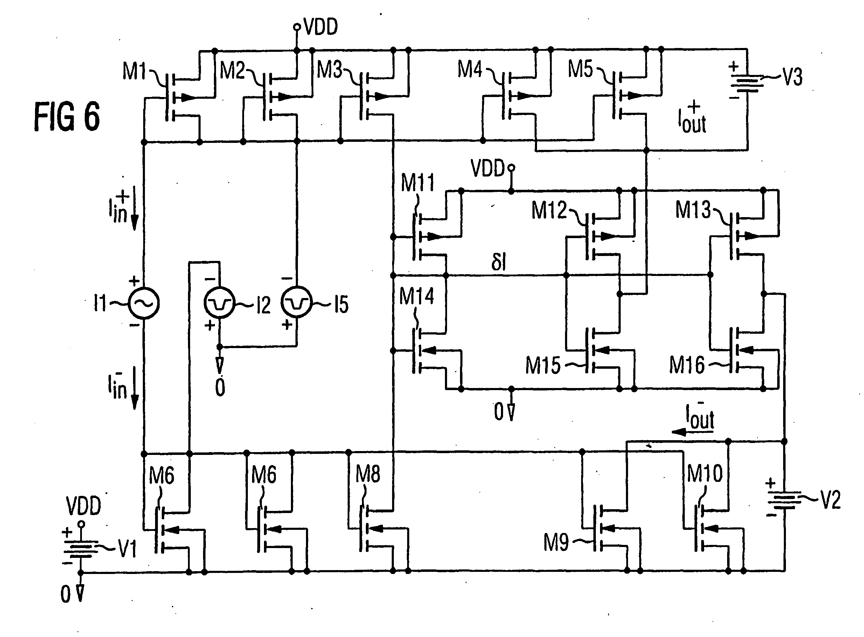

In Fig. 6 ist eine Anordnung zur Simulation des Verhaltens eines bevorzugten Stromspiegels dargestellt.

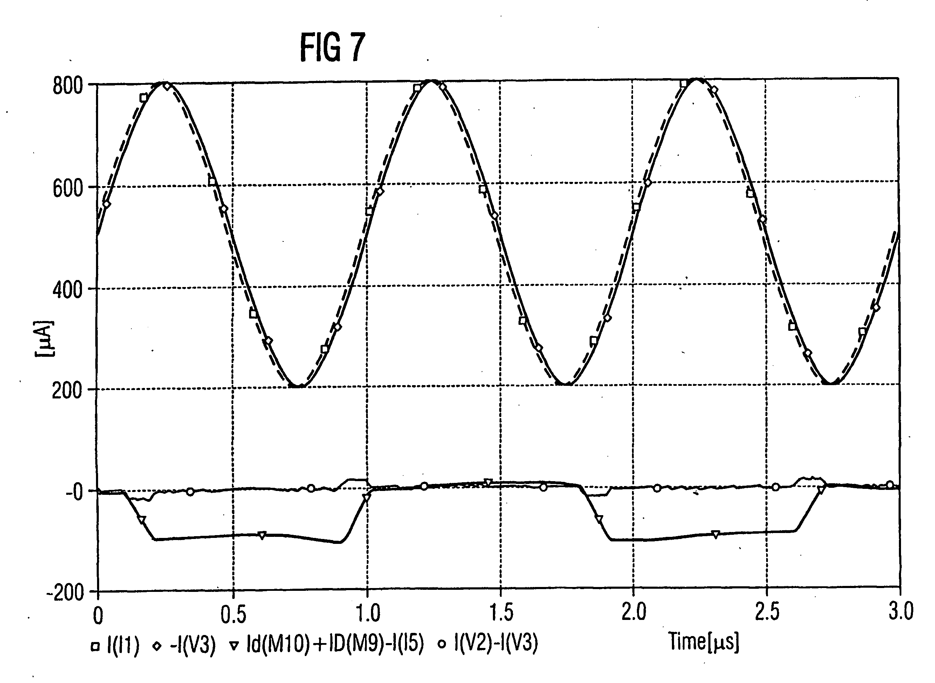

Eine Zeitabhängigkeit von Strömen in dem Stromspiegel ist in Fig. 7 wiedergegeben.

Oben dargestellt ist das sinusförmige Ausgangssignal (I(V3)) der Schaltung sowie das sinusförmige Eingangssignal (I(I1)). Unten im Diagramm ist das Differenzsignal der Ausgangsströme mit und ohne die erfindungsgemäße common-mode Unterdrückung dargestellt. Wie an der Kurve (I(V2)-I(V3)) zu erkennen ist, wird die von den Pulsquellen 12 und 15 (siehe Figur 6) induzierte rechteckförmige Störung (common mode) von der volldiffentiellen Schaltung weitgehend unterdrückt.

Die Ausführung der Erfindung mit CMOS-Transistoren ist in Figur 3, in Figur 5 und in Figur 6 dargestellt, die jeweils die selbe Schaltung wiedergeben.

Zusätzlich sind in Figur 6 an den Anschlüssen $I_{in}$ und $I_{out}$ noch Signalquellen angeschlossen. Außerdem ist dort eine Spannungsversorgung VDD sowie Hilfsspannungsquellen V2 und V3 eingezeichnet, die zum besseren Verständnis der Funktionsweise der Schaltung eingezeichnet sind.

Die Funktionsweise der erfindungsgemäßen Stromspiegelschaltung kann auf einfache Weise anhand Figur 4 erläutert werden, wobei die dabei gemachten Ausführungen auch für die Ausführungsformen gemäß Figur 3, Figur 5 und Figur 6 gelten.

Die Erfindung kann auch in folgende Merkmale gegliedert werden:

- Stromspiegel, bei dem ein Eingangsstrom ($I_{in}$) in einer Stromsenke nichtlinear in eine Spannung gewandelt wird, wobei die Spannung zur Ansteuerung einer Stromquelle ($I_{out}$) mit im Wesentlichen gleicher Übertragungskennlinie dient, wobei der Stromspiegel eine weitere spannungsgesteuerte Stromquelle enthält, die einen Hilfsstrom ($a \cdot I_{out} = a \cdot n \cdot I_{in}$) liefert.

- Stromspiegel wie zuvor, wobei in einem zusätzlichen Zweig eine zusätzliche spannungsgesteuerte Stromquelle einen zusätzlichen Hilfsstrom erzeugt.

- Stromspiegel wie zuvor, wobei der Hilfsstrom und der zusätzliche Hilfsstrom so addiert werden, daß ein Fehlerstrom δI resultiert.

- Stromspiegel wie zuvor, wobei der resultierende Fehlerstrom mit einem Übertragungsverhältnis von 1:2a von den differenziellen Ausgangssignalen abgezogen wird.

- Stromspiegel wie zuvor, wobei im Wesentlichen gilt: a = 1:2.

- Stromspiegel wie zuvor, wobei im Wesentlichen gilt a = 1.

- Stromspiegel wie zuvor, obei wenigstens eine der Stromquellen durch wenigstens einen Transistor gebildet wird.

- Stromspiegel wie zuvor, wobei die Stromquelle kaskadierte Transistoren enthält.

**Patentansprüche**

1. Differentielle Stromspiegelschaltung, bei der von einem positiven Eingangsstrom ($I_{in}$ +) bzw. von einem negativen Eingangsstrom ($I_{in}$ -) mindestens je eine Kopie erzeugbar ist, indem durch Einrichtungen (M1, M2; M6, M7) jeweils der Eingangsstrom ($I_{in}$ +, $I_{in}$ -) in je eine Spannung umgewandelt wird, wobei die betreffende Spannung zur Ansteuerung je einer Stromquelle (M4, M5; M9, M10) zur Erzeugung einer Kopie des positiven Eingangsstroms ($I_{in}$ +) bzw. des negativen Eingangsstroms ($I_{in}$-) dient,
**dadurch gekennzeichnet, daß**
eine Einrichtung (M3; M8) zur Erzeugung je eines Hilfsstroms vorgesehen ist, der ein vielfaches bzw. ein Bruchteil des jeweiligen Eingangsstroms ($I_{in}$ +, $I_{in}$ -) ist,
wobei weiterhin eine Einrichtung (M11, M12, M13, M14, M15, M16) zur Extraktion eines Störsignals ($I_{cor}$) durch Addierung der beiden Hilfsströme und je eine Einrichtung zur Erzeugung des positiven Ausgangsstroms ($I_{out}$ +) und des negativen Ausgangsstroms ($I_{out}$ -) durch Abziehen des Störsignals ($I_{cor}$) von einer Kopie des positiven Eingangsstrom ($I_{in}$ +) bzw. von einer Kopie des negativen Eingangsstrom ($I_{in}$ -) vorgesehen ist.

2. Differentielle Stromspiegelschaltung nach Anspruch 1,
**dadurch gekennzeichnet, daß**
die beiden Hilfsströme als die Hälfte des jeweiligen Eingangsstroms ($I_{in}$ +, $I_{in}$ -) erzeugbar sind.

3. Differentielle Stromspiegelschaltung nach Anspruch 1 oder Anspruch 2,
**dadurch gekennzeichnet, daß**
die Einrichtung zur Erzeugung des positiven Ausgangsstroms ($I_{out}$ +) und des negativen Ausgangsstroms ($I_{out}$ -) durch Abziehen des Störsignals ($I_{cor}$) von einer Kopie des positiven Eingangsstrom ($I_{in}$ +) bzw. von einer Kopie des negativen Eingangsstrom ($I_{in}$ -) wenigstens einen komplementären Stromspiegel (M11, M14; M12, M15; M13, M16) aufweist.

4. Differentielle Stromspiegelschaltung nach einem der vorhergehenden Ansprüche,
**dadurch gekennzeichnet, daß**
je ein Vielfaches einer Kopie des Eingangsstroms ($I_{in}$ +, $I_{in}$ -) als positiver Ausgangsstrom ($I_{out}$ +) bzw. als negativer Ausgangsstrom ($I_{out}$ -) erzeugbar ist.

5. Differentielle Stromspiegelschaltung nach einem der vorhergehenden Ansprüche,
**dadurch gekennzeichnet, daß**
mehrere Kopien des Eingangsstroms ($I_{in}$ +, $I_{in}$ -) erzeugbar sind.

**Claims**

1. Differential current mirror circuit in which at least one copy each of a positive input current ($I_{in}$+) or, respectively, of a negative input current ($I_{in}$-) can be generated by the input current ($I_{in}$+, $I_{in}$-) being in each case converted by devices (M1, M2; M6, M7) into a voltage, the relevant voltage being used for driving in each case one current source (M4, M5; M9, M10) for generating a copy of the positive input current ($I_{in}$+) and, respectively, of the negative input current ($I_{in}$-), **characterized in that** a device (M3; M8) for generating in each case one auxiliary current is provided which is a multiple or a fraction of the respective input current ($I_{in}$+, $I_{in}$-), where a device (M11, M12, M13, M14, M15, M16) is also provided for extracting an interference signal ($I_{cor}$) by adding the two auxiliary currents and one device each for generating the positive output current ($I_{out}$+) and the negative output current ($I_{out}$-) by subtracting the interference signal ($I_{cor}$) from a copy of the positive input current ($I_{in}$+) and, respectively, from a copy of the negative input current ($I_{in}$-).

2. Differential current mirror circuit according to Claim 1, **characterized in that** the two auxiliary currents can be generated as one half of the respective input current ($I_{in}$+, $I_{in}$-).

3. Differential current mirror circuit according to Claim 1 or Claim 2, **characterized in that** the device for generating the positive output current ($I_{out}$+) and the negative output current ($I_{out}$-) by subtracting the interference signal ($I_{cor}$) from a copy of the positive input current ($I_{in}$+) and, respectively, from a copy of the negative input current ($I_{in}$-) has at least one complementary current mirror (M11, M14; M12, M15; M13, M16).

4. Differential current mirror circuit according to one of the preceding claims, **characterized in that** in each case a multiple of a copy of the input current (Iin+, $I_{in}$-) can be generated as a positive output current ($I_{out}$+) and, respectively, as negative output current ($I_{out}$-).

5. Differential current mirror circuit according to one of the preceding claims, **characterized in that** a number of copies of the input current ($I_{in}$+, $I_{in}$-) can be generated.


**Revendications**

1. Circuit miroir de courant différentiel avec lequel au moins une copie d'un courant d'entrée positif ($I_{in}$ +) ou d'un courant d'entrée négatif ($I_{in}$ -) peut à chaque fois être généré en convertissant le courant d'entrée ($I_{in}$ +, $I_{in}$ -) correspondant à chaque fois en une tension par le biais de dispositifs (M1, M2 ; M6, M7), la tension concernée servant à commander à chaque fois une source de courant (M4, M5 ; M9, M10) pour générer une copie du courant d'entrée positif ($I_{out}$ +) ou du courant d'entrée négatif ($I_{in}$ -), **caractérisé en ce qu'**il est prévu un dispositif (M3 ; M8) pour générer à chaque fois un courant auxiliaire qui est un multiple ou une fraction du courant d'entrée ($I_{in}$ +, $I_{in}$ -) correspondant, un dispositif (M11, M12, M13, M14, M15, M16) étant en plus prévu pour extraire un signal parasite ($I_{cor}$) en additionnant les deux courants auxiliaires et à chaque fois un dispositif étant prévu pour générer le courant de sortie positif ($I_{out}$ +) et le courant de sortie négatif ($I_{out}$ -) en retirant le signal parasite ($I_{cor}$) d'une copie du courant d'entrée positif ($I_{in}$ +) ou d'une copie du courant d'entrée négatif ($I_{in}$ -).

2. Circuit miroir de courant différentiel selon la revendication 1, **caractérisé en ce que** les deux courants auxiliaires peuvent être générés en tant que moitié du courant d'entrée ($I_{in}$ +, $I_{in}$ -) correspondant.

3. Circuit miroir de courant différentiel selon la revendication 1 ou la revendication 2, **caractérisé en ce que** le dispositif pour générer le courant de sortie positif ($I_{out}$ +) et le courant de sortie négatif ($I_{out}$ -) en retirant le signal parasite ($I_{cor}$) d'une copie du courant d'entrée positif ($I_{in}$ +) ou d'une copie du courant d'entrée négatif ($I_{in}$ -) présente au moins un miroir de courant complémentaire (M11, M14 ; M12, M15 ; M13, M16).

4. Circuit miroir de courant différentiel selon l'une des revendications précédentes, **caractérisé en ce qu'**un multiple d'une copie du courant d'entrée ($I_{in}$ +, $I_{in}$ -) peut être à chaque fois généré sous la forme d'un courant de sortie positif ($I_{out}$ +) ou d'un courant de sortie négatif ($I_{out}$ -).

5. Circuit miroir de courant différentiel selon l'une des revendications précédentes, **caractérisé en ce que** plusieurs copies du courant d'entrée ($I_{in}$ +, $I_{in}$ -) peuvent être générées.

# FIG 1

# FIG 2

8

# FIG 3

## FIG 4

## FIG 5

FIG 6

FIG 7

EP 1 282 940 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0651502 A

**In der Beschreibung aufgeführte Nicht-Patentliteratur**

- **BUCH C. TOUMAZOU ; F.J. LIDGEY ; D.G. HAIGH.** *Analogue IC design: the current mode approach,* 1990
- **KENNETH R. LAKER ; WILLY M.C. SANSEN.** Design of analog integrated circuits and systems. Mc-Graw-Hill Verlag, 456ff
- **BENGT JONSSON.** Switched-Current Circuits: from Building Blocks to Mixed Analog-Digital Systems. *Vortrag im Department of Electronics, Electronic System Design, Electrum 229,* 25. Januar 1999